# EUROPEAN PATENT APPLICATION

(11) **EP 4 546 973 A1**
(43) Date of publication of application: **30.04.2025**
(21) Application number: 24315480.4
(22) Date of filing: 17.10.2024
(51) Int. Cl.: H10D 30/47, H10D 30/01, H10D 64/23, H10D 64/27, H10D 62/17, H10D 64/20, H10D 62/85

(54) **ISOLATION OF P-GAN HEMT BY USE OF GATE RING**

(30) Priority: 25.10.2023 US 202318494401
(71) Applicant: STMicroelectronics International N.V., 1228 Plan-les-Ouates, Geneva (CH)
(72) Inventor: Constant, Aurore, 37100 TOURS (FR); Wakrim, Tarik, 37000 TOURS (FR); Iucolano, Ferdinando, 95030 GRAVINA DI CATANIA (IT)
(74) Representative: Cabinet Beaumont

(57) **Abstract**

A process for forming a high electron mobility transistor (HEMT) includes forming a semiconductor heterostructure including a channel layer of the HEMT, forming a gate (150) layer of GaN on the channel layer, and patterning the gate layer to form a first gate finger, a second gate finger, and a gate arc connecting the first gate finger and the second gate finger. The process includes forming an isolation mask covering an active region of the semiconductor heterostructure and the gate arc and performing an ion bombardment process on an inactive region (142) of the semiconductor heterostructure exposed by the isolation mask.

## Description

### BACKGROUND

### Technical Field

The present disclosure relates to field-effect high electron mobility transistors (HEMT) and to a manufacturing process thereof.

### Description of the Related Art

HEMT devices are known in which a conductive channel is based on the formation of layers of two-dimensional electron gas (2DEG) with high mobility at a heterojunction, *i.e.*, at the interface between semiconductor materials with different bandgaps. For instance, HEMT devices are known based on the heterojunction between an aluminum and GaN (AlGaN) layer and a GaN (GaN) layer.

HEMT devices based on AlGaN/GaN heterojunctions or heterostructures provide a wide range of advantages that make them particularly suitable for and widely used for different applications. For instance, the high breakdown threshold of HEMT devices is exploited for high-performance power switches; the high electron mobility in the conductive channel allows to obtain high-frequency amplifiers; moreover, the high electron concentration in the 2DEG allows to obtain a low ON-state resistance (R_{ON}).

AlGaN/GaN HEMTs may normally be in a depletion-mode (normally-on). However, for practical applications, enhancement mode (normally-off) devices are utilized to promote safe operation and drive circuit simplification. Several approaches to achieve normally-off HEMTs have been proposed, i.e., recessed gate, fluorine plasma incorporation under the gate, or p-GaN gate. In the case of p-GaN gate devices, an isolation implant may be used to form inactive regions of an HEMT heterostructure. However, ion implantation isolation regions may not form sharp interfaces with active regions of GaN HEMTs. Lateral ion penetration may generate defects and cause parasitic channel formation at the sides of HEMTs.

All of the subject matter discussed in the Background section is not necessarily prior art and should not be assumed to be prior art merely as a result of its discussion in the Background section. Along these lines, any recognition of problems in the prior art discussed in the Background section or associated with such subject matter should not be treated as prior art unless expressly stated to be prior art. Instead, the discussion of any subject matter in the Background section should be treated as part of the inventors' approach to the particular problem, which, in and of itself, may also be inventive.

### BRIEF SUMMARY

Embodiments of the present disclosure provide an HEMT and corresponding manufacturing method that overcomes the drawbacks of other HEMTs and formation processes. During processing of the HEMT, a pGaN gate is formed and patterned on a semiconductor heterostructure including a channel layer. The pGaN gate includes a straight first gate finger, a straight second gate finger, and a semicircular gate arc connecting the first gate finger and the second gate finger.

An isolation mask is formed over the heterostructure and entirely covers the pGaN gate, with an edge that is very close to the edge of the gate arc. An isolation implantation process is then performed in the presence of the mask to implant ions into the portions of the heterostructure exposed by the mask. The implantation process renders the exposed portions of the heterostructure inactive in the HEMT device.

Due to the placement of the isolation mask and the shape of the pGaN gate, the heterostructure below the gate fingers receives little or no lateral penetration of the isolation implant species. The result is improved performance of the HEMT, with reduced parasitic channel formation at the sides of the HEMT.

In one embodiment, a method includes forming a semiconductor heterostructure including a channel layer of a HEMT. The method includes forming a gate layer of GaN on the channel layer and patterning the gate layer to form a first gate finger, a second gate finger, and a gate arc connecting the first gate finger and the second gate finger. The method includes forming an isolation mask covering an active region of the semiconductor heterostructure and the gate arc and performing an ion bombardment process on an inactive region of the semiconductor heterostructure exposed by the isolation mask.

In one embodiment, a device includes a semiconductor heterostructure including an active region and an inactive region and having a channel layer of an HEMT. The device includes a gate layer of GaN on the channel layer and including a first gate finger, a second gate finger, and a gate arc connecting the first gate finger and the second gate finger. The device includes a source region between the first gate finger and the second gate finger and in contact with the channel layer between. The channel layer has a higher concentration of an isolation dopant species in the inactive region than in the active region. An entirety of the gate arc is directly above the active region.

In one embodiment, a method includes forming a semiconductor heterostructure including a channel layer of AlGaN of a high electron mobility transistor (HEMT) and forming a gate layer of GaN on the channel layer. The method includes patterning the gate layer to form a first gate finger extending in a first direction, a second gate finger extending the first direction, and a gate arc connecting the first gate finger and the second gate finger. The method includes forming an isolation mask covering an active region of the semiconductor heterostructure and the gate arc and having a substantially straight edge adjacent to the gate arc and at least 500 nm away from the first gate finger and the second gate finger. The method includes defining an inactive region of the semiconductor heterostructure laterally outside the isolation mask by performing an ion bombardment process in a present of the isolation mask.

An embodiment provides a method, comprising:
- forming a semiconductor heterostructure including a channel layer of a high electron mobility transistor (HEMT);
- forming a gate layer of GaN on the channel layer;
- patterning the gate layer to form a first gate finger, a second gate finger, and a gate arc connecting the first gate finger and the second gate finger;
- forming an isolation mask covering an active region of the semiconductor heterostructure and the gate arc; and
- performing an ion bombardment process in the presence of the isolation mask.

According to an embodiment, the ion bombardment is performed on an inactive region of the semiconductor heterostructure exposed by the isolation mask.

According to an embodiment, the method comprises forming a source region positioned between the first gate finger and the second gate finger and in contact with the channel layer in the active region.

According to an embodiment, the source region contacts a portion of the channel layer outside of the active region.

An embodiment provides a device, comprising:
- a semiconductor heterostructure including an active region and an inactive region and having a channel layer of a high electron mobility transistor (HEMT);
- a gate layer of GaN on the channel layer and including a first gate finger, a second gate finger, and a gate arc connecting the first gate finger and the second gate finger;
- a source region between the first gate finger and the second gate finger and in contact with the channel layer between, wherein the channel layer has a higher concentration of an isolation dopant species in the inactive region than in the active region, wherein an entirety of the gate arc is directly above the active region.

According to an embodiment, the first and second gate fingers extend in a first direction.

According to an embodiment, the isolation mask, or a boundary between the active region and an inactive region, has a substantially straight edge extending in a second direction transverse to the first direction past the first gate finger, the second gate finger, and the gate arc.

According to an embodiment, the isolation mask, or a boundary between the active region and an inactive region, has a first portion that is arced in a shape of an outer edge of the gate arc adjacent to the gate arc.

According to an embodiment, the isolation mask, or a boundary between the active region and an inactive region, has a second portion that is straight and extends in a second direction transverse to the first direction and connects to the first portion.

According to an embodiment, the method comprises:
- removing the isolation mask after performing the ion bombardment process; and
- forming the source region after removing the isolation mask.

According to an embodiment, the method comprises forming a drain region in contact with the channel region in a same process that forms the source region.

According to an embodiment, the method comprises doping the gate layer with p-type dopants.

According to an embodiment, the channel layer includes AlGaN.

According to an embodiment, a drain region of the HEMT is in contact with the channel region in the inactive region and in the active region.

According to an embodiment, the drain region has a substantially straight edge, the source region having a semicircular edge.

According to an embodiment:
- said channel layer is of AlGaN;
- said first gate finger and said second gate finger extend in a first direction;
- said isolation mask has a substantially straight edge adjacent to the gate arc and at least 500 nm away from the first gate finger and the second gate finger; and
- said ion bombardment process defines said inactive region of the semiconductor heterostructure laterally outside the isolation mask.

According to an embodiment, the ion bombardment process implants nitrogen atoms in the inactive region.

According to an embodiment, the method comprises:
- removing the isolation mask;
- forming a source region of the HEMT between the first and second gate fingers and in contact with the channel layer only at the active region; and
- forming a drain region of the HEMT in contact with the channel layer at the active region and the inactive region.

### BRIEF DESCRIPTION OF THE SEVERAL VIEWS OF THE DRAWINGS

Figures 1A-1J include cross-sectional and top views of an integrated circuit at various stages of forming an HEMT in the integrated circuit, in accordance with one embodiment.
Figure 2 is a top view of an integrated circuit including an HEMT, in accordance with one embodiment.
Figure 3 is a top view of an integrated circuit including an HEMT, in accordance with one embodiment.
Figure 4 is a flow diagram of a method for forming an HEMT, in accordance with one embodiment.
Figure 5 is a flow diagram of a method for forming an HEMT, in accordance with one embodiment.

### DETAILED DESCRIPTION

In the following description, certain specific details are set forth in order to provide a thorough understanding of various disclosed embodiments. However, one skilled in the relevant art will recognize that embodiments may be practiced without one or more of these specific details, or with other methods, components, materials, etc. In other instances, well-known systems, components, and circuitry associated with integrated circuits have not been shown or described in detail, to avoid unnecessarily obscuring descriptions of the embodiments.

Unless the context requires otherwise, throughout the specification and claims which follow, the word "comprise" and variations thereof, such as, "comprises" and "comprising" are to be construed in an open, inclusive sense, that is as "including, but not limited to." Further, the terms "first," "second," and similar indicators of sequence are to be construed as interchangeable unless the context clearly dictates otherwise.

Reference throughout this specification to "one embodiment" or "an embodiment" means that a particular feature, structure or characteristic described in connection with the embodiment is included in at least one embodiment. Thus, the appearances of the phrases "in one embodiment" or "in an embodiment" in various places throughout this specification are not necessarily all referring to the same embodiment. Furthermore, the particular features, structures, or characteristics may be combined in any suitable manner in one or more embodiments.

As used in this specification and the appended claims, the singular forms "a," "an," and "the" include plural referents unless the content clearly dictates otherwise. It should also be noted that the term "or" is generally employed in its broadest sense, that is as meaning "and/or" unless the content clearly dictates otherwise.

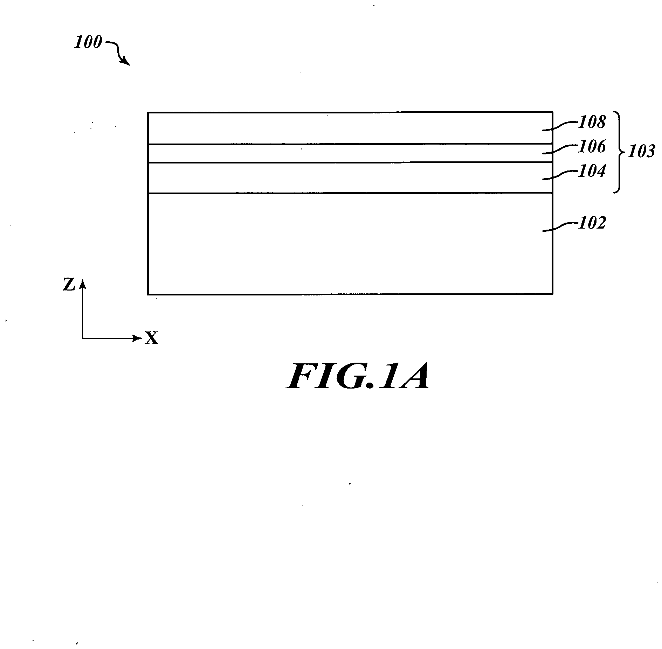

Figure 1A is a cross-sectional view of an integrated circuit 100 at an intermediate stage of forming an HEMT device, in accordance with one embodiment. In Figure 1A, the integrated circuit 100 includes a substrate 102, in accordance with one embodiment. The substrate 102 can include a semiconductor material. In one embodiment, the substrate 102 includes silicon. However, the substrate 102 can include other types of semiconductor materials. In some embodiments, the substrate 102 may include one or more layers of dielectric material. The substrate 102 can include other materials suitable for forming an HEMT.

While the substrate 102 is shown as a single layer in Figure 1A, in practice, the substrate 102 may include multiple layers. For example, the substrate 102 may include a base layer of silicon, a layer of aluminum nitride and the silicon, and a buffer layer on the layer of aluminum nitride, as will be described in more detail below. The substrate 102 can also include silicon carbide, sapphire, aluminum nitride, or other suitable materials.

In one embodiment, the integrated circuit 100 includes a semiconductor heterostructure 103 formed on the substrate 102. Although the heterostructure 103 is shown as being formed on the substrate 102, in practice, the heterostructure 103 may include a portion of the substrate 102 including the aluminum nitride and the buffer layer.

The heterostructure 103 can be formed with an epitaxial growth process. The epitaxial growth process grows the semiconductor heterostructure 103 epitaxially from the substrate 102. The various separate layers of the heterostructure 103 can be formed by adjusting the parameters of the epitaxial growth process in situ. For example, the epitaxial growth process can include flowing one or more gases or other materials into a deposition chamber in which the integrated circuit 100 (at this stage part of a semiconductor wafer) is positioned. The temperature, pressure, and materials can be adjusted throughout the epitaxial growth process to form the various layers of the heterostructure 103. In some cases, when one layer of the heterostructure 103 is complete, a purging process may be performed to purge any excess gases or byproducts from the deposition chamber before beginning growth of the next layer.

In one embodiment, the substrate epitaxial growth process forms a semiconductor layer of aluminum nitride as part of the substrate 102. The aluminum nitride layer may be formed as a precursor to forming a plurality of GaN layers. Aluminum nitride may be selected as the first layer because gallium can be damaging to a base layer of the substrate 102, in particular when the base layer includes silicon. Accordingly, the epitaxial growth process first forms the layer of aluminum nitride so that layers of GaN may subsequently be formed.

The buffer layer may include a super lattice of a plurality of layers formed on the aluminum nitride layer during the first epitaxial growth process. In an example in which the substrate 102 includes a layer of aluminum nitride and subsequent layers of GaN are to be formed, the first layer of the super lattice can include a layer of AlGaN in which the percentage of aluminum is high and the percentage of gallium is low to enable epitaxial growth from the layer of aluminum nitride. Subsequent layers of the super lattice include AlGaN with increasing concentrations of gallium and decreasing concentrations of aluminum. Finally, a top layer of the super lattice may include GaN without any aluminum. The super lattice may include up to 200 layers. The super lattice can include other materials and structures without departing from the scope of the present disclosure. The super lattice can also include AlGaN and AlN.

After formation of the super lattice, a layer 104 is formed on the substrate 102. In particular, the layer 104 may be formed on the super lattice of the substrate 104. In an example in which the super lattice is a transitional structure including a plurality of layers that gradually transition from aluminum nitride to GaN, the layer 104 can include GaN. In one embodiment, the layer 104 of GaN includes p- type or n-type dopants. In one embodiment, the layer 104 of GaN is doped with carbon atoms, which can produce n-type or p-type doping depending on the concentration of carbon. In another embodiment, the layer 104 of GaN is doped with magnesium atoms. The total thickness of the layer 104 may be about 1 µm. The total thickness of the super lattice may also be about 2 µm. The composition of the super lattice and the layer of GaN 104 may facilitate formation of an HEMT device that can be operated with very high voltages. For example, the composition of the super lattice and the layer of GaN 104 may facilitate operation of an HEMT device with more than 600 V between terminals of the HEMT device. Other materials, thicknesses, and operating voltages can be utilized without departing from the scope of.the present disclosure.

In one embodiment, the layer 104 may include multiple layers. In one embodiment, the layer 104 may include a channel layer GaN doped intrinsically that does not include any doping.

In one embodiment, the layer 104 may include multiple layers. For example, the layer 104 may include a layer GaN doped with p-type dopants as described above. The layer 104 may also include a back barrier layer of GaN and the p-doped region of GaN.

In one example, the back barrier layer may be doped with magnesium atoms. The back barrier layer may be between 50 nm and 300 nm in thickness. Other materials and thicknesses can be utilized for the back barrier layer without departing from the scope of the present disclosure. Furthermore, in some embodiments, the back barrier layer may not be present.

In one embodiment, the heterostructure 103 includes a barrier layer 106 and a channel layer 104. The interface between the barrier layer 106 and the layer 104 corresponds to the layer in which a two-dimensional electron gas (2DEG) is formed during operation of the transistor. Free electrons flow through the channel region based on biasing between source and drain regions and the control voltage applied to the gate electrode, as will be set forth in more detail below.

In one embodiment, the barrier layer 106 includes AlGaN. The percentage of aluminum may be between 1% and 50%, though other compositions can be utilized without departing from the scope of the present disclosure. The AlGaN layer can have a thickness between 1 nm and 30 nm. Other compositions and thicknesses can be utilized for the AlGaN layer without departing from the scope of the present disclosure.

In one embodiment, the barrier layer 106 may include a thin layer of aluminum nitride between the layer of GaN and the layer of AlGaN. The barrier layer 106 can have various compositions without departing from the scope of the present disclosure.

The semiconductor heterostructure 103 includes a gate layer 108, and the channel layer 104 and the barrier layer 106. The gate layer 108 may include GaN heavily doped with P type dopants. Accordingly, the gate layer 108 may be termed a p-GaN layer. The heavy doping of the gate layer 108 results in a high conductivity of the gate layer 108. This, in part, enables the semiconductor material of the gate layer 108 to act as a conducting gate layer. The gate layer 108 can have a thickness between 50 nm and 150 nm. Other thicknesses and materials can be utilized without departing from the scope of the present disclosure.

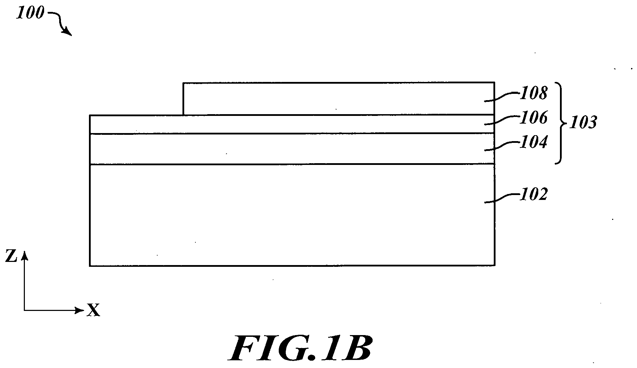

In Figure 1B, the gate layer 108 has been patterned to expose a portion of the barrier layer 106. The gate layer 108 can be patterned in accordance with a photolithography process in which a mask is formed on the gate layer 108 in a desired pattern. An etching process can then be performed to remove the gate layer 108 at the locations exposed by the mask, resulting in a patterned gate layer 108.

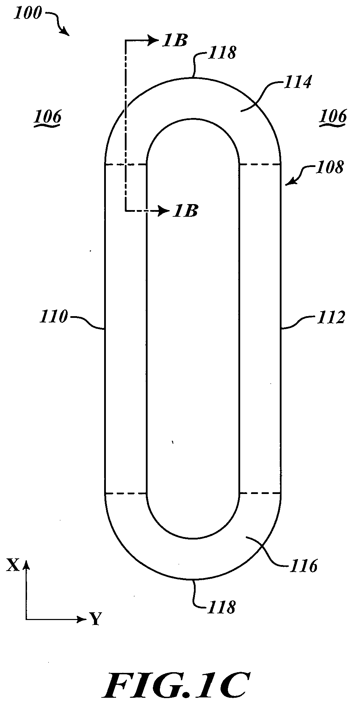

Figure 1C is a top view of the integrated circuit 100 at the stage of processing shown in Figure 1B, in accordance with one embodiment. The top view of Figure 1C illustrates that the gate layer 108, after patterning, a straight first gate finger 110 extending in the X direction and a straight second gate finger 112 extend in parallel to the straight first gate finger 110 in the X direction. The gate layer 108 includes a gate arc 114 connecting the first gate finger 110 and the second gate finger 112 at a top of Figure 1C. The gate layer 108 includes a gate arc 116 connecting the first gate finger 110 and the second gate finger 112 at a bottom of Figure 1C. The gate layer 108 also includes an outer edge 118. Figure 1C also illustrates cut lines 1B corresponding to the cut lines on which the cross-section of Figure 1B is taken. The view of Figure 1C illustrates that the barrier layer 106 is exposed portions not covered by the gate layer 108. The patterned gate layer 108 may also be termed a gate ring.

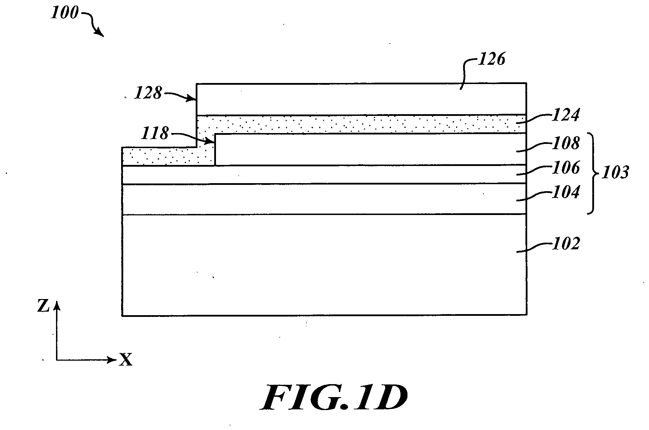

Figure 1D is a cross-sectional view of the integrated circuit 100, in accordance with one embodiment. In Figure 1D, a dielectric layer 124 has been formed on the gate layer 108 and on the exposed portions of the barrier layer 106. The dielectric layer can include, aluminum oxide, aluminum oxynitride, aluminum nitride, hafnium oxide, silicon nitride, silicon oxide, or other suitable dielectric materials.

In Figure 1D, a mask 126 has been formed on the dielectric layer 124. The mask 126 corresponds to an isolation mask that will be utilized to delineate an active region of the heterostructure 103 from an inactive region of the heterostructure 103. More particularly, the isolation mask be utilized to perform an isolation implantation process during which ions are implanted into the portions of the heterostructure 103 not covered by isolation mask 126. This implantation process renders the exposed portions of the heterostructure 103 inactive regions of the heterostructure 103, while the nonexposed portions of the heterostructure 103 correspond to active regions of the heterostructure 103.

The mask 126 can correspond to a hard mask including a dielectric material, a conductive material, a ceramic material, or another material through which ions will not pass during the subsequent ion implantation process. The mask 126 can be patterned using a photolithography process.

As can be seen in Figure 1D, the mask 126 includes an edge 128. The edge 128 is positioned beyond the edge 118 of the gate layer 108 in the X direction. This lateral distance between the edge 128 and the edge 118 helps ensure that any lateral implantation of ions in the ion implantation process will not extend below the first and second fingers 110/112. In one embodiment, the lateral distance between the edge 128 of the mask 126 and the edge 118 of the gate layer 108 is less than 5 µm. Other dimensions, materials, and shapes can be utilized for the mask 126 without departing from the scope of the present disclosure.

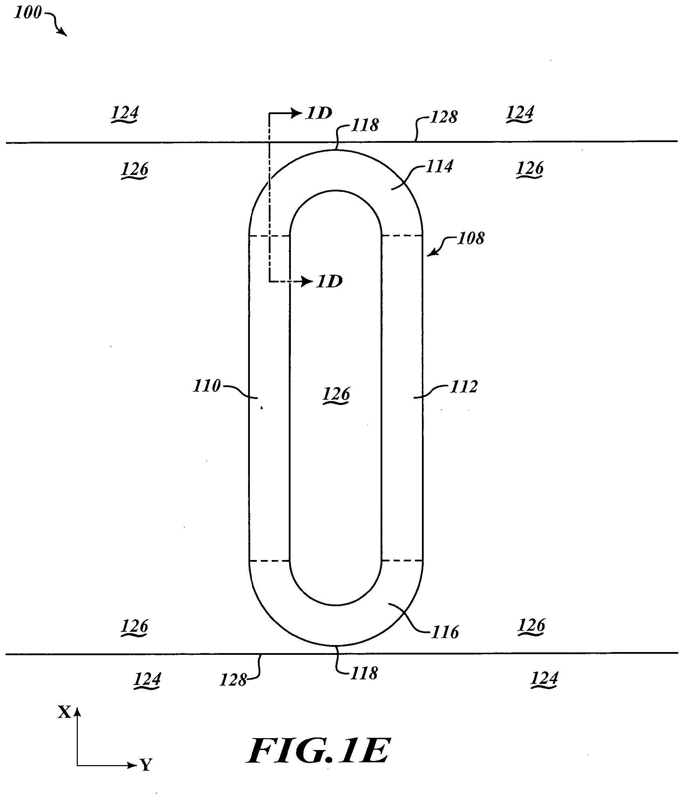

Figure 1E is a top view of the integrated circuit 100 at the stage of processing shown in Figure 1D, in accordance with one embodiment. The top view of Figure 1E illustrates the position of the edge 128 of the mask 126. Figure 1D also illustrates, in dashed lines, the position of the gate layer 108 below mask 126. The edges 128 of the mask 126 are straight and extend in the direction transverse, and substantially perpendicular to the first and second gate fingers 110 and 112. Furthermore, the edges 128 extend beyond the edge 118 of the gate layer 108 such that the entirety of the gate arcs 114 and 116 are covered by the mask 126.

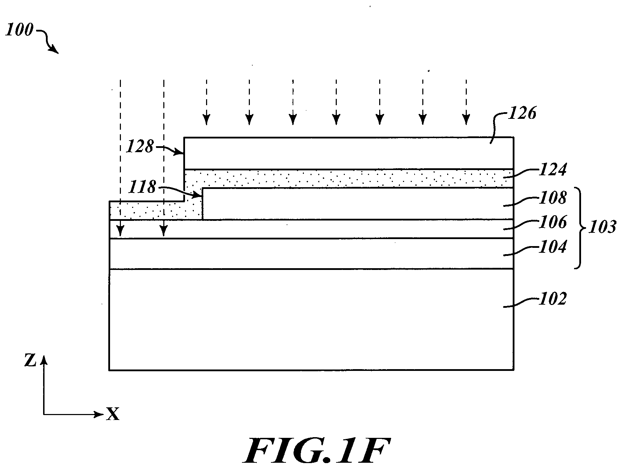

Figure 1F is a cross-sectional view of the integrated circuit 100 during an ion implantation process, in accordance with one embodiment. The ion implantation process can correspond to an isolation implantation process. During the implantation process, ions (atoms or compounds with a net electric charge) bombard the integrated circuit 100. The ions do not pass through the mask 126. The ions penetrate into the layers 104 and 106 at the areas exposed by the mask 126. The penetration of the ions into the layers 104 and 106 substantially destroys the semiconductor lattice of the semiconductor materials of the heterostructure. This causes the exposed portions of the heterostructure to become inactive regions. The portions of the heterostructure 103 that are covered by the mask 126 remain active regions of the heterostructure 103. The active regions of the heterostructure 103 are part of the HEMT that will be formed.

In one embodiment, the ions destroy the crystal lattice of the layers 104 and 106 at the exposed regions. In one embodiment, the ions can include nitrogen, argon and boron ions. In one embodiment, the ions include nitrogen molecules carrying a net charge. Other types of particles can be utilized for the isolation implantation process without departing from the scope of the present disclosure.

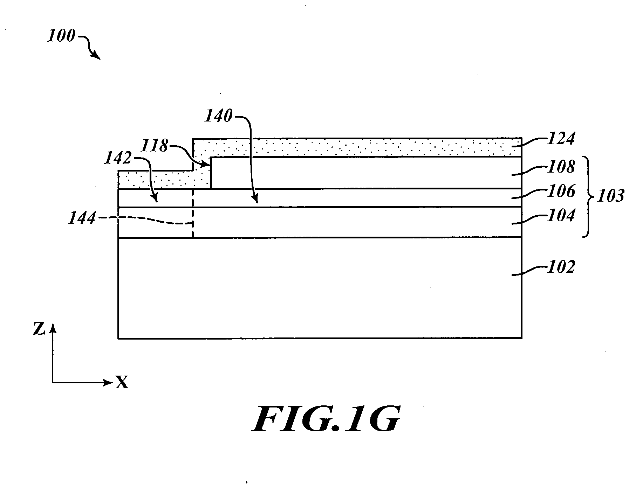

Figure 1G is a cross-sectional view of the integrated circuit 100 after the ion implantation process of Figure 1F, in accordance with one embodiment. The mask 106 has been removed. Figure 1G illustrates the active region 140 of the heterostructure 103 and the inactive region 142 of the heterostructure 103. Figure 1G also illustrates a boundary 144 between the inactive region 142 and the active region 140.

In practice, there may be some lateral implantation of ions into areas not covered by the mask 106. However, the position of the mask relative to the shape and position of the gate layer 108 helps ensure that there will not be substantial lateral implantation into regions of the heterostructure 103 directly below the gate fingers 110 and 112. The inactive region 142 is different from the active region 140 due to a higher concentration of nitrogen in the inactive region 142 compared to the active region 140. The inactive region 142 is different from the active region 140 due to the damage or destroyed crystal lattice of the semiconductor layers of the heterostructure 103 in the inactive region 142.

Figure 1G illustrates the boundary 144 as being at a location corresponding to an edge 128 of the mask 126. However, in practice, there will be some lateral implantation of ions and below the mask 126. The boundary 144 may correspond to a location at which the concentration of implanted ions has a particular value.

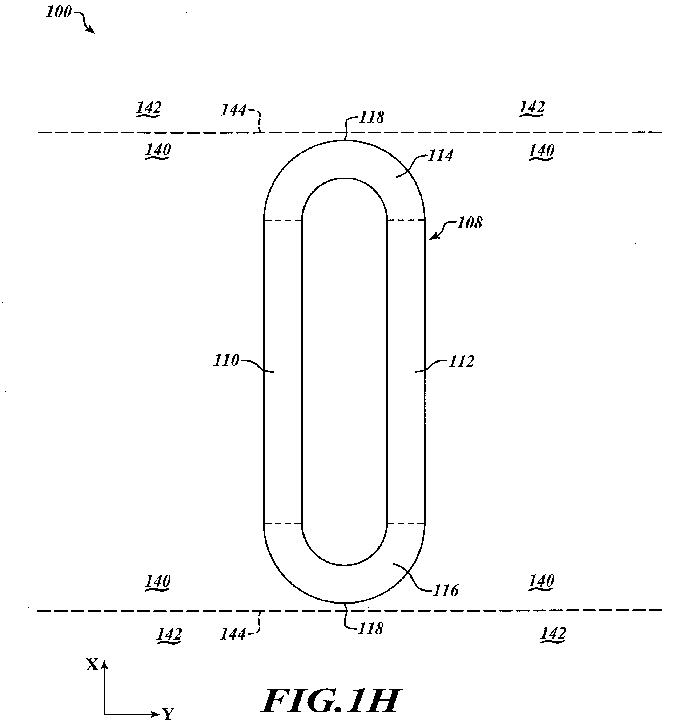

Figure 1H is a top view of the integrated circuit 100 of Figure 1G, in accordance with one embodiment. Figure 1H illustrates the boundary 144 between the active region 140 and the inactive region 142.

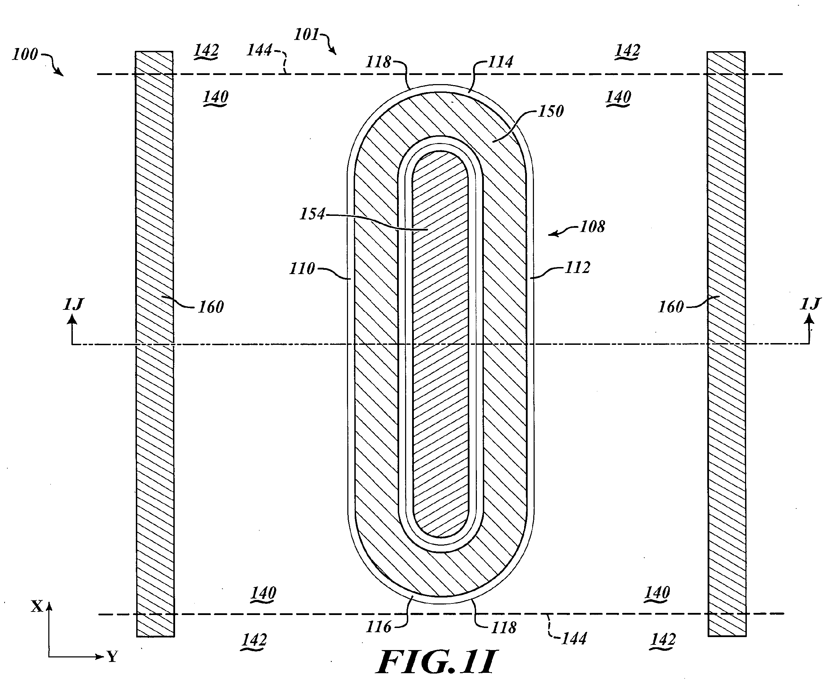

Figure 1I is a top view of an integrated circuit 100 after further formation of elements of the HEMT 101, in accordance with one embodiment. In Figure 1G, a source region 154 and drain regions 160 have been formed, in accordance with one embodiment. A photolithography process can be performed to form trenches that extend partially into the barrier layer 106. A source/drain metal can then be deposited and patterned to form the source region 154 and the drain regions 160. The source/drain metal can include titanium, tantalum, aluminum, titanium nitride, or other suitable conductive materials. The source/drain metal can be deposited by PVD, ALD, CVD, or other suitable deposition processes.

In Figure 1I, a gate electrode 150 has been formed on the gate layer 108. The gate electrode 150 is made of a gate metal. The gate metal can include titanium nitride, titanium, aluminum, tungsten and can be deposited by PVD, ALD, CVD, or other suitable deposition processes. The gate metal can include other materials and configurations without departing from the scope of the present disclosure. For example, while the gate metal is shown as a single gate metal, in practice, multiple gate metals may be present.

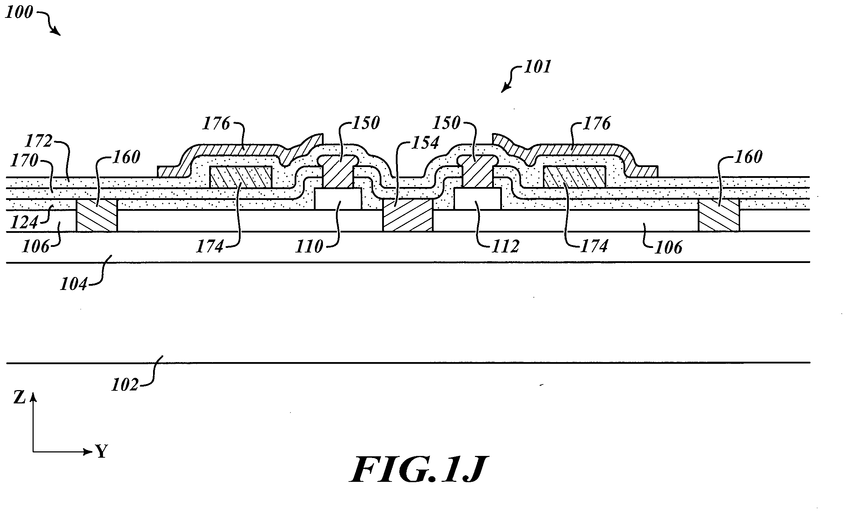

For simplicity, the top view of Figure 1I does not illustrate other components of the HEMT 101 that may be present. For example, field plates, metal lines, and other components may be present, as shown in Figure 1J.

The HEMT 101 can include various other layers including passivation layers and other dielectric layers to isolate and protect the source/drain metals in the gate electrode 150. The HEMT can be operated by applying a control voltage to the gate electrode 150 and biasing the source region 154 and the drain regions 160. Depending on the control and bias voltages, the HEMT may be turned on or turned off. When the HEMT is turned on, the current of the electron gas may flow through the channel layer 106 and under the bottom of the gate layer 108 between the drain regions 160 and the source region 154.

In Figure 1I, the source region 154 has rounded ends and has been formed laterally between the first gate finger 110, the second gate finger 112, and the gate arcs 114/116. The drain regions 160 extend further in the X direction than does the source region 154. In particular, the drain region 160 extend into the inactive region 142, whereas the source region 154 is positioned entirely within the active region 140. Furthermore, the drain regions 160 have straight ends that extends in the early in the Y direction, whereas the source region 154 has rounded ends.

The HEMT 101 structure of Figure 1I provides several benefits in comparison to other possible solutions. For example, the threshold voltage of the HEMT 101 may be increased. For example, the threshold voltage may be about 1 V. Furthermore, the drain current may have a much sharper rise upon reaching a threshold voltage. Additionally, the HEMT 101 of Figure 1I provides lower drain leakage in the off state. The on resistance (the effective resistance between the source and drain in the saturation region) of the HEMT 101 is not increased with respect to other solutions.

Figure 1J is a cross-sectional view of the integrated circuit 100 of Figure 1I taken along cut lines 1J, in accordance with one embodiment. The cross-sectional view of Figure 1J illustrates additional components not shown in Figure 1I. For example, Figure 1J illustrates a dielectric layer 170 and the dielectric layer 124. Figure 1J illustrates a dielectric layer 172 and the dielectric layer 170. Figure 1J illustrates field plates 174 that may be utilized to apply selected electric fields to the channel region in addition to the gate voltage. Figure 1J also illustrates metal lines 176 on the dielectric layer 172.

Figure 1J illustrates that the source region 154 and the drain regions 160 are formed in the trenches through the dielectric layers 170 and 124 and the barrier layer 106. Accordingly, the source region 154 and the drain region 160 are in contact with the channel layer 106. In Figure 1J, the source region 154 and the drain regions 160 terminate at the top surface of the layer 104. However, the source region 154 and the drain regions 160 may terminate within the channel layer 106 or within the layer 104. Various other configurations of an HEMT 101 can be utilized without departing from the scope of the present disclosure. Though not shown in Figure 1I and 1J, gate contacts, source contacts, and drain contacts may be present to electrically connect the source region 154, the drain regions 160, and the gate 150 other conductive structures formed above.

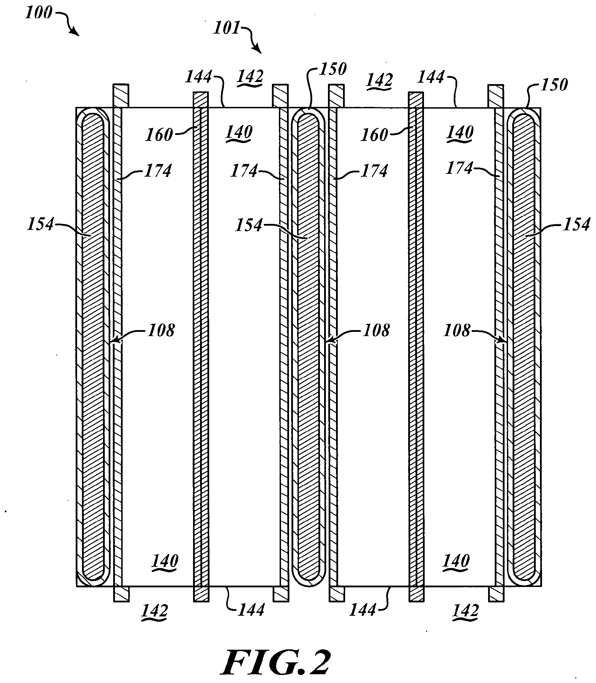

Figure 2 is a top view of an integrated circuit 100 including an HEMT 101, in accordance with one embodiment. Figure 2 illustrates that an HEMT 101 can include multiple gate layers 108, multiple source regions 154 and multiple drain regions 160. An HEMT may include dozens of source regions 154, drain regions 160, and gate rings 108. The field plates 174 are also shown adjacent to the gate rings 108.

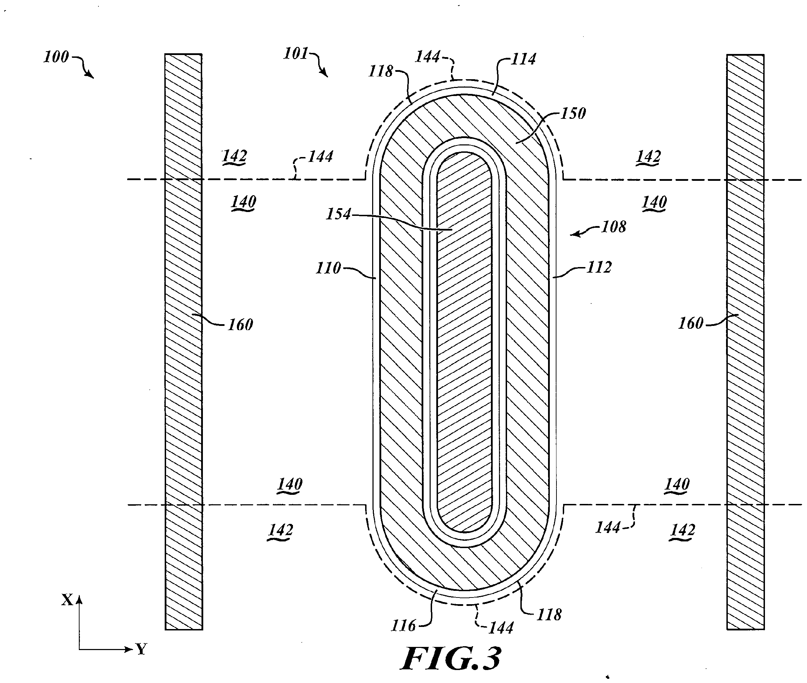

Figure 3 is a top view of an integrated circuit 100 including an HEMT 101, in accordance with one embodiment. The HEMT 101 of Figure 3 is substantially similar to the HEMT of Figure 1I, except that the active region 140 has a boundary 144 that is not a straight line. Instead, the boundary has linear portions extending laterally in the Y direction from the gate fingers 110 and 112, and an arc portion that is semicircular substantially in the same shape as the edge 118 of the gate arcs 114 and 116.

The boundary 144 between the active region 140 and the inactive region 142 in Figure 3 can be achieved by forming the mask layer 126 of Figure 1D with semicircular protrusions similar to the desired pattern of the boundary 144. The subsequent isolation bombardment process will result in an active region 140 and an inactive region 142 sharing the boundary 144 is shown in Figure 3.

In one embodiment, an HEMT 101 can be formed with the retracted gate ring 108 shown in Figure 1I, but without an isolation implant process. In other words, in one embodiment, the mask 126 is not formed in the isolation bombardment processes are performed. The result is that there is not an inactive region in which the crystal structure has been destroyed by an isolation bombardment process.

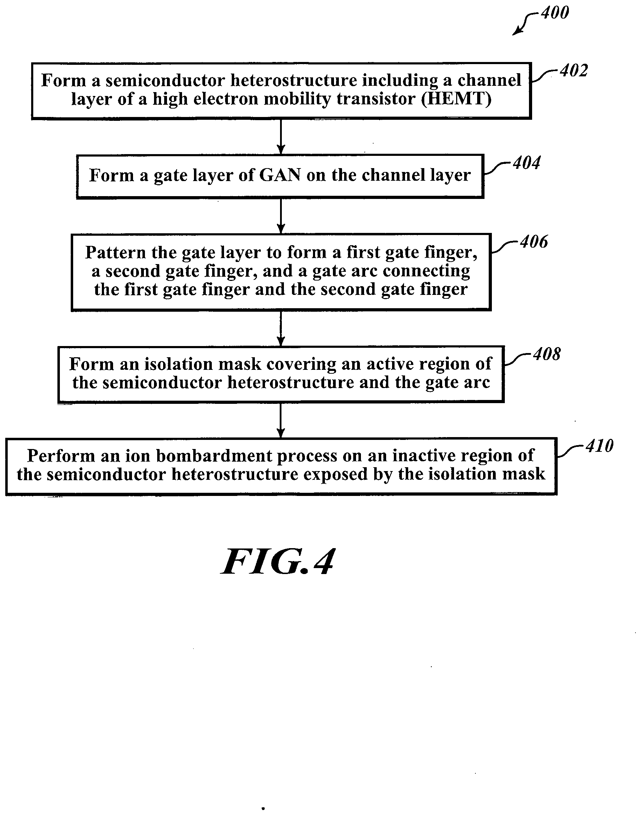

Figure 4 is a flow diagram of a method 400 for forming an HEMT, in accordance with one embodiment. The method 400 can utilize processes, structures, and systems described in relation to Figures 1A-3. At 402, the method 400 includes forming a semiconductor heterostructure including a channel layer of an HEMT. At 404, the method 400 includes forming a gate layer of GaN on the channel layer. At 406, the method 400 includes patterning the gate layer to form a first gate finger, a second gate finger, and a gate arc connecting the first gate finger and the second gate finger. At 408, the method 400 includes forming an isolation mask covering an active region of the semiconductor heterostructure and the gate arc. At 410, the method 400 includes performing an ion bombardment process on an inactive region of the semiconductor heterostructure exposed by the isolation mask.

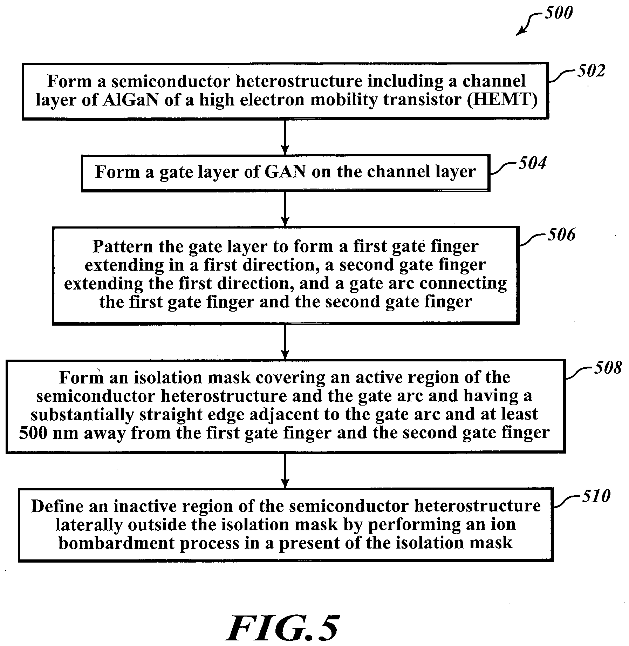

Figure 5 is a flow diagram of a method 500 for forming an HEMT, in accordance with one embodiment. The method 500 can utilize processes, structures, and systems described in relation to Figures 1A-3. At 502, the method 500 includes forming a semiconductor heterostructure including a channel layer of AlGaN of an HEMT. At 504, the method 500 includes forming a gate layer of GaN on the channel layer. At 506, the method 500 includes patterning the gate layer to form a first gate finger extending in a first direction, a second gate finger extending the first direction, and a gate arc connecting the first gate finger and the second gate finger. At 508, the method 500 includes forming an isolation mask covering an active region of the semiconductor heterostructure and the gate arc and having a substantially straight edge adjacent to the gate arc and at least 500 nm away from the first gate finger and the second gate finger. At 510, the method 500 includes defining an inactive region of the semiconductor heterostructure laterally outside the isolation mask by performing an ion bombardment process in a present of the isolation mask.

In one embodiment, a method includes forming a semiconductor heterostructure including a channel layer of a HEMT. The method includes forming a gate layer of GaN on the channel layer and patterning the gate layer to form a first gate finger, a second gate finger, and a gate arc connecting the first gate finger and the second gate finger. The method includes forming an isolation mask covering an active region of the semiconductor heterostructure and the gate arc and performing an ion bombardment process on an inactive region of the semiconductor heterostructure exposed by the isolation mask.

In one embodiment, the method includes forming a source region positioned between the first gate finger and the second gate finger and in contact with the channel layer in the active region.

In one embodiment, the source region does not contact the channel layer outside of the active region.

In one embodiment, the first and second gate fingers extend in a first direction and the isolation mask has a substantially straight edge extending in a second direction transverse to the first direction past the first gate finger, the second gate finger, and the gate arc.

In one embodiment, the first and second gate fingers extend in a first direction and an edge of the isolation mask has a first portion that is arced in a shape of an outer edge of the gate arc adjacent to the gate arc.

In one embodiment, the edge of the isolation mask has a second portion that is straight and extends in a second direction transverse to the first direction and connects to the first portion.

In one embodiment, the method includes removing the isolation mask after performing the ion bombardment process and forming the source region after removing the isolation mask.

In one embodiment, the method includes forming a drain region in contact with the channel region in a same process that forms the source region.

In one embodiment, the ion bombardment process includes implanting nitrogen ions in the inactive region.

In one embodiment, the method includes doping the gate layer with p-type dopants.

In one embodiment, the channel region includes AlGaN.

In one embodiment, a device includes a semiconductor heterostructure including an active region and an inactive region and having a channel layer of an HEMT. The device includes a gate layer of GaN on the channel layer and including a first gate finger, a second gate finger, and a gate arc connecting the first gate finger and the second gate finger. The device includes a source region between the first gate finger and the second gate finger and in contact with the channel layer between. The channel layer has a higher concentration of an isolation dopant species in the inactive region than in the active region. An entirety of the gate arc is directly above the active region.

In one embodiment, the first and second gate fingers extend in a first direction and a boundary between the active region and the inactive region has a substantially straight edge extending in a second direction transverse to the first direction past the first gate finger, the second gate finger, and the gate arc.

In one embodiment, the first and second gate fingers extend in a first direction and wherein a boundary between the active region and the inactive region has a first portion that is arced in a shape of an outer edge of the gate arc adjacent to the gate arc.

In one embodiment, the boundary between the active region and the inactive region has a second portion that is straight and extends in a second direction transverse to the first direction and connects to the first portion.

In one embodiment, the device includes a drain region of the HEMT in contact with the channel region in the inactive region and in the active region.

In one embodiment, the drain region, has a substantially straight edge, wherein the source region has a semicircular edge.

In one embodiment, a method includes forming a semiconductor heterostructure including a channel layer of AlGaN of a high electron mobility transistor (HEMT) and forming a gate layer of GaN on the channel layer. The method includes patterning the gate layer to form a first gate finger extending in a first direction, a second gate finger extending the first direction, and a gate arc connecting the first gate finger and the second gate finger. The method includes forming an isolation mask covering an active region of the semiconductor heterostructure and the gate arc and having a substantially straight edge adjacent to the gate arc and at least 500 nm away from the first gate finger and the second gate finger. The method includes defining an inactive region of the semiconductor heterostructure laterally outside the isolation mask by performing an ion bombardment process in a present of the isolation mask.

In one embodiment, the ion bombardment process implants nitrogen atoms in the inactive region of the semiconductor heterostructure.

In one embodiment, the method includes removing the isolation mask, forming a source region of the HEMT between the first and second gate fingers and in contact with the channel layer only at the active region, and forming a drain region of the HEMT in contact with the channel layer at the active region and the inactive region.

Example embodiments of the present disclosure are summarized here. Other embodiments can also be understood from the entirety of the specification and the examples.

Example 1. A method, comprising:
forming a semiconductor heterostructure including a channel layer of a high electron mobility transistor (HEMT);
forming a gate layer of GaN on the channel layer;
patterning the gate layer to form a first gate finger, a second gate finger, and a gate arc connecting the first gate finger and the second gate finger;
forming an isolation mask covering an active region of the semiconductor heterostructure and the gate arc; and
performing an ion bombardment process on an inactive region of the semiconductor heterostructure exposed by the isolation mask.

Example 2. The method of example 1, comprising forming a source region positioned between the first gate finger and the second gate finger and in contact with the channel layer in the active region.

Example 3. The method of example 2, wherein the source region contacts a portion of the channel layer outside of the active region.

Example 4. The method of example 2, wherein the first and second gate fingers extend in a first direction, wherein the isolation mask has a substantially straight edge extending in a second direction transverse to the first direction past the first gate finger, the second gate finger, and the gate arc.

Example 5. The method of example 2, wherein the first and second gate fingers extend in a first direction, wherein an edge of the isolation mask has a first portion that is arced in a shape of an outer edge of the gate arc adjacent to the gate arc.

Example 6. The method of example 5, wherein the edge of the isolation mask has a second portion that is straight and extends in a second direction transverse to the first direction and connects to the first portion.

Example 7. The method of example 2, comprising:
removing the isolation mask after performing the ion bombardment process; and
forming the source region after removing the isolation mask.

Example 8. The method of example 7, comprising forming a drain region in contact with the channel region in a same process that forms the source region.

Example 9. The method of example 1, wherein the ion bombardment process includes implanting nitrogen ions in the inactive region.

Example 10. The method of example 1, comprising doping the gate layer with p-type dopants.

Example 11. The method of example 1, wherein the channel region includes AlGaN.

Example 12. A device, comprising:
a semiconductor heterostructure including an active region and an inactive region and having a channel layer of a high electron mobility transistor (HEMT);
a gate layer of GaN on the channel layer and including a first gate finger, a second gate finger, and a gate arc connecting the first gate finger and the second gate finger;
a source region between the first gate finger and the second gate finger and in contact with the channel layer between, wherein the channel layer has a higher concentration of an isolation dopant species in the inactive region than in the active region, wherein an entirety of the gate arc is directly above the active region.

Example 13. The device of example 12, wherein the first and second gate fingers extend in a first direction, wherein a boundary between the active region and the inactive region has a substantially straight edge extending in a second direction transverse to the first direction past the first gate finger, the second gate finger, and the gate arc.

Example 14. The device of example 12, wherein the first and second gate fingers extend in a first direction, wherein a boundary between the active region and the inactive region has a first portion that is arced in a shape of an outer edge of the gate arc adjacent to the gate arc.

Example 15. The device of example 14, wherein the boundary between the active region and the inactive region has a second portion that is straight and extends in a second direction transverse to the first direction and connects to the first portion.

Example 16. The device of example 12, comprising a drain region of the HEMT in contact with the channel region in the inactive region and in the active region.

Example 17. The device of example 16, wherein the drain region has a substantially straight edge, wherein the source region has a semicircular edge.

Example 18. A method, comprising:
forming a semiconductor heterostructure including a channel layer of AlGaN of a high electron mobility transistor (HEMT);
forming a gate layer of GaN on the channel layer;
patterning the gate layer to form a first gate finger extending in a first direction, a second gate finger extending the first direction, and a gate arc connecting the first gate finger and the second gate finger;
forming an isolation mask covering an active region of the semiconductor heterostructure and the gate arc and having a substantially straight edge adjacent to the gate arc and at least 500 nm away from the first gate finger and the second gate finger; and
defining an inactive region of the semiconductor heterostructure laterally outside the isolation mask by performing an ion bombardment process in a present of the isolation mask.

Example 19. The method of example 18, wherein the ion bombardment process implants nitrogen atoms in the inactive region of the semiconductor heterostructure.

Example 20. The method of example 19, comprising:
removing the isolation mask;
forming a source region of the HEMT between the first and second gate fingers and in contact with the channel layer only at the active region; and
forming a drain region of the HEMT in contact with the channel layer at the active region and the inactive region.

The various embodiments described above can be combined to provide further embodiments. These and other changes can be made to the embodiments in light of the above-detailed description. In general, in the following claims, the terms used should not be construed to limit the claims to the specific embodiments disclosed in the specification and the claims, but should be construed to include all possible embodiments along with the full scope of equivalents to which such claims are entitled. Accordingly, the claims are not limited by the disclosure.

## Claims

1. A method, comprising:
forming a semiconductor heterostructure including a channel layer of a high electron mobility transistor (HEMT);
forming a gate layer of GaN on the channel layer;
patterning the gate layer to form a first gate finger, a second gate finger, and a gate arc connecting the first gate finger and the second gate finger;
forming an isolation mask covering an active region of the semiconductor heterostructure and the gate arc; and
performing an ion bombardment process in the presence of the isolation mask.

2. The method of claim 1, wherein the ion bombardment is performed on an inactive region of the semiconductor heterostructure exposed by the isolation mask.

3. The method of claim 1 or 2, comprising forming a source region positioned between the first gate finger and the second gate finger and in contact with the channel layer in the active region.

4. The method of claim 3, wherein the source region contacts a portion of the channel layer outside of the active region.

5. A device, comprising:
a semiconductor heterostructure including an active region and an inactive region and having a channel layer of a high electron mobility transistor (HEMT);
a gate layer of GaN on the channel layer and including a first gate finger, a second gate finger, and a gate arc connecting the first gate finger and the second gate finger;
a source region between the first gate finger and the second gate finger and in contact with the channel layer between, wherein the channel layer has a higher concentration of an isolation dopant species in the inactive region than in the active region, wherein an entirety of the gate arc is directly above the active region.

6. The method of any of claims 1 to 4, or the device of claim 5, wherein the first and second gate fingers extend in a first direction.

7. The method of claim 6, wherein the isolation mask, or the device of claim 6 wherein a boundary between the active region and an inactive region, has a substantially straight edge extending in a second direction transverse to the first direction past the first gate finger, the second gate finger, and the gate arc.

8. The method of claim 6, wherein an edge of the isolation mask, or the device of claim 6 wherein a boundary between the active region and an inactive region, has a first portion that is arced in a shape of an outer edge of the gate arc adjacent to the gate arc.

9. The method of claim 8, wherein the edge of the isolation mask, or the device of claim 8 wherein the boundary between the active region and an inactive region, has a second portion that is straight and extends in a second direction transverse to the first direction and connects to the first portion.

10. The method of any of claims 2 to 4, 6 to 9, comprising:
removing the isolation mask after performing the ion bombardment process; and
forming the source region after removing the isolation mask.

11. The method of claim 10, comprising forming a drain region in contact with the channel region in a same process that forms the source region.

12. The method of any of claims 1 to 4, 6 to 11, comprising doping the gate layer with p-type dopants.

13. The method of any of claims 1 to 4, 6 to 12, or the device of any of claims 5 to 9, wherein the channel layer includes AlGaN.

14. The method of any of claims 2 to 4, 6 to 13, or the device of any of claims 5 to 9, 13, comprising a drain region of the HEMT in contact with the channel region in the inactive region and in the active region.

15. The method or the device of claim 14, wherein the drain region has a substantially straight edge, wherein the source region has a semicircular edge.

16. The method of claim 1, wherein:
said channel layer is of AlGaN;
said first gate finger and said second gate finger extend in a first direction;
said isolation mask has a substantially straight edge adjacent to the gate arc and at least 500 nm away from the first gate finger and the second gate finger; and
said ion bombardment process defines said inactive region of the semiconductor heterostructure laterally outside the isolation mask.

17. The method of any of claims 2 to 4, 6 to 16, wherein the ion bombardment process implants nitrogen atoms in the inactive region.

18. The method of claim 17 in its dependency of claim 16, comprising:
removing the isolation mask;
forming a source region of the HEMT between the first and second gate fingers and in contact with the channel layer only at the active region; and
forming a drain region of the HEMT in contact with the channel layer at the active region and the inactive region.
